(19) **Europäisches Patentamt / European Patent Office / Office européen des brevets**

(11) **EP 3 933 485 B1**

(12) **FASCICULE DE BREVET EUROPEEN**

(45) Date de publication et mention
de la délivrance du brevet:
**23.11.2022 Bulletin 2022/47**

(21) Numéro de dépôt: **21181857.0**

(22) Date de dépôt: **25.06.2021**

(51) Classification Internationale des Brevets (IPC):
**G02B 26/06** (2006.01)    **G02B 26/10** (2006.01)
**G02B 27/00** (2006.01)

(52) Classification Coopérative des Brevets (CPC):
**G02B 26/06; G02B 26/101; G02B 26/103;
G02B 26/106; G02B 27/0087**

(54) **SCANNER OPTIQUE**

OPTISCHER SCANNER

OPTICAL SCANNER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.07.2020 FR 2006923**

(43) Date de publication de la demande:
**05.01.2022 Bulletin 2022/01**

(73) Titulaire: **COMMISSARIAT À L'ÉNERGIE
ATOMIQUE ET AUX
ÉNERGIES ALTERNATIVES
75015 Paris (FR)**

(72) Inventeurs:
  • **MOLLARD, Laurent
    38054 GRENOBLE CEDEX 09 (FR)**
  • **DIEPPEDALE, Christel
    38054 GRENOBLE CEDEX 09 (FR)**
  • **FANGET, Stéphane
    38054 GRENOBLE CEDEX 09 (FR)**
  • **FOWLER, Daivid
    38054 GRENOBLE CEDEX 09 (FR)**

(74) Mandataire: **Brevalex
    95, rue d'Amsterdam
    75378 Paris Cedex 8 (FR)**

(56) Documents cités:
    **WO-A1-2018/222727    FR-A1- 2 923 092**

  • **HOLMSTROM SVEN T S ET AL: "MEMS Laser
    Scanners: A Review", JOURNAL OF
    MICROELECTROMECHANICAL SYSTEMS, IEEE
    SERVICE CENTER, US, vol. 23, no. 2, 1 avril 2014
    (2014-04-01), pages 259-275, XP011544460, ISSN:
    1057-7157, DOI: 10.1109/JMEMS.2013.2295470
    [extrait le 2014-03-31]**

EP 3 933 485 B1

**Description**

## DOMAINE TECHNIQUE

La présente invention se rapporte au domaine des microsystèmes opto électromécaniques (« MOEMS » selon la terminologie Anglo-Saxonne). En particulier, la présente invention concerne un scanner optique permettant de balayer l'espace environnant par extraction lumineuse au niveau de deux faces parallèles d'une poutre.

A cet égard, le scanner selon la présente invention combine une poutre pourvue d'une partie mobile à laquelle une flexion ou une torsion peut être imposée, et un réseau à commande de phase.

L'agencement du réseau à commande de phase dans la partie mobile de la poutre permet en particulier d'extraire selon l'une et l'autre de deux faces parallèles de la poutre un rayonnement lumineux susceptible d'être émise par une source lumineuse.

## ÉTAT DE LA TECHNIQUE ANTÉRIEURE

Les scanners ou les micro-scanners 2D sont des dispositifs permettant de balayer avec un faisceau lumineux une scène selon une, voire deux, dimensions. Ces scanners peuvent notamment être mis en œuvre dans des dispositifs de type LIDAR (« Light Détection And Ranging systems ») à des fins de détection ou d'imagerie.

En pratique, le balayage d'une surface ou d'un objet par un faisceau lumineux peut être réalisé au moyen d'un ou plusieurs micro-miroirs mobiles.

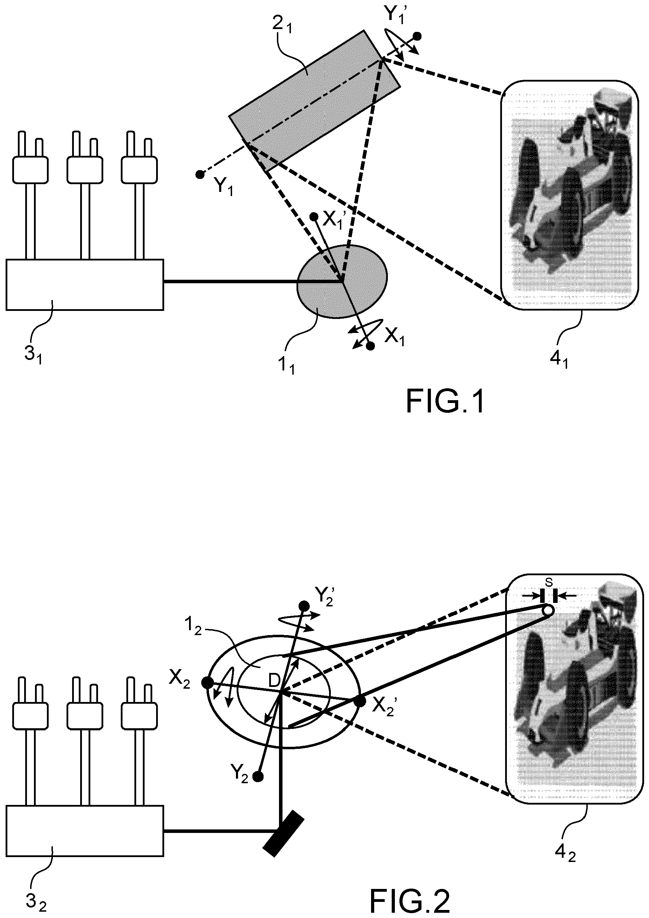

A cet égard, la figure 1 (extraite du document [1] cité à la fin de la description) illustre une première architecture possible d'un tel dispositif pourvu de deux micro-miroirs, dits respectivement premier micro-miroir $1_1$ et deuxième micro-miroir $2_1$, agencés pour pivoter autour, respectivement, d'un premier axe pivot $X_1X_1$' et d'un deuxième axe pivot $Y_1Y_1$' non parallèles. En particulier, ces deux micro-miroirs $1_1$ et $2_1$ sont agencés de sorte qu'un faisceau lumineux émis par une source lumineuse $3_1$ soit réfléchi par le premier micro-miroir $1_1$ en direction du deuxième micro-miroir $2_1$ qui le réfléchit à son tour en direction, par exemple, d'un écran $4_1$. La rotation de chacun des micro-miroirs $1_1$ et $2_1$ autour de leur axe pivot respectif permet ainsi d'effectuer un balayage d'une surface avec le faisceau lumineux, par exemple, à des fins d'imagerie ou de détection.

Une telle architecture n'est cependant pas satisfaisante.

En effet, cette dernière, du fait de la présence de deux micro-miroirs, reste peut compacte.

Par ailleurs, cette architecture requiert un alignement précis des deux micro-miroirs, et est, par voie de conséquence, difficile à réaliser.

Enfin, les micro-miroirs sont également susceptibles de subir un endommagement, notamment par un échauffement induit par le faisceau lumineux.

Afin de pallier ces problèmes, une deuxième architecture, illustrée à la figure 2 (extraite du document [1] cité à la fin de la description), peut être envisagée. Cette dernière met en œuvre un unique micro-miroir $1_2$ monté pivotant autour de deux axes pivot $X_2X_2$' et $Y_2Y_2$' non parallèles. L'oscillation de ce micro-miroir $1_2$ autour de l'un et l'autre des deux axes pivots $X_2X_2$' et $Y_2Y_2$' permet ainsi de balayer la surface d'un écran $4_1$ au moyen faisceau lumineux issue d'une source lumineuse $3_2$ et réfléchie par ledit micro-miroir $1_2$.

Toutefois, cette deuxième architecture n'est pas non plus satisfaisante.

En effet, à l'instar de la première architecture, le micro-miroir $1_2$ est également susceptible de subir un échauffement induit par le faisceau lumineux.

Par ailleurs, cette deuxième architecture est également sensible à l'alignement de la source lumineuse $3_2$ et du micro-miroir $1_2$. L'alignement entre ces deux éléments est notamment sensible aux chocs subits par le dispositif mais également aux conditions de température et de pression imposées à ce dernier.

En outre, les oscillations du micro-miroir autour de l'un et l'autre des deux axes pivots $X_2X_2$' et $Y_2Y_2$', induites par un actionneur, ne sont jamais découplées de sorte que des diaphonies (« Crosstalk » selon la terminologie Anglo-Saxonne) mécaniques sont susceptibles d'intervenir.

De manière alternative aux architectures présentées ci-avant, des micro-scanners 2D à émetteur optique à commande de phase ou à réseau optique à commande de phase (« OPA » ou « Optical Phased Array » selon la terminologie Anglo-Saxonne) ont pu être proposés.

Ces derniers peuvent comprendre une pluralité de sources optiques susceptibles d'émettre chacune un rayonnement lumineux. Chacune de ses sources optiques est par ailleurs associée à des moyens de modulation de phase destinés à déphaser les rayonnements optiques les uns par rapport aux autres de manière à faire varier l'angle de propagation du rayonnement combiné issu de l'ensemble des sources optiques. Selon une configuration avantageuse, les sources optiques peuvent être issues d'une même source principale.

Ce principe de fonctionnement peut être extrapolé à une matrice 2D de sources optiques permettant un balayage au moyen d'un faisceau optique suivant deux directions différentes, par exemple perpendiculaires l'une par rapport à l'autre.

Toutefois, ces dispositifs ne sont pas non plus satisfaisants.

En effet, l'espace effectivement balayé par le faisceau lumineux reste relativement limité. Le document WO2018222727 divulgue un scanner optique comprenant une poutre actionnée en flexion ou en torsion.

Par conséquent, un but de la présente invention est de proposer un dispositif de balayage lumineux qui permet de balayer un espace plus important que les dispositifs connus de l'état de la technique.

Un autre but de la présente invention est de proposer un dispositif de balayage lumineux qui est compact.

## EXPOSÉ DE L'INVENTION

Les buts de l'invention sont, au moins en partie, atteints par un scanner optique qui comprend :

- un support plan fixe ;
- une poutre, pourvue d'une première face et d'une deuxième face, maintenue solidaire par une de ses extrémités, dite extrémité fixe, au support plan et perpendiculaire une face principale dudit support ;
- un actionneur agencé pour imposer soit une flexion soit une torsion à une partie mobile de la poutre s'étendant à partir d'une extrémité libre de ladite poutre et opposée à l'extrémité fixe ;
- une source optique apte à émettre un faisceau optique principal d'une longueur d'onde λ ;
- une pluralité de guides d'ondes disposés sur ou dans la poutre et destinés à diviser le faisceau optique principal en une pluralité de faisceaux optiques secondaires ;
- un réseau optique à commande de phase qui comprend une pluralité de déphaseurs optiques chacun couplé à un guide d'onde, disposés sur ou dans une section d'émission de la partie mobile et qui s'étend à partir de l'extrémité libre, la section d'émission présentant une transparence adaptée pour permettre une extraction lumineuse à partir de la première face et de la deuxième face.

La mise en œuvre combinée d'une mise en mouvement de la poutre et d'un réseau optique à commande de phase permettant d'émettre un rayonnement lumineux de part et d'autre de ladite poutre permet d'étendre les surfaces ou zones effectivement balayées.

Par ailleurs, ce dispositif qui ne nécessite que peu ou pas l'alignement du faisceau incident, est plus simple à mettre en œuvre que les systèmes connus de l'état de la technique.

En outre cette combinaison d'une poutre pourvue d'une partie mobile et d'un réseau optique à commande de phase lui assure une compacité appréciable au regard des dispositifs connus de l'état de la technique.

Selon un mode de mise en œuvre, la poutre comprend de sa première face vers sa seconde face une première couche, une deuxième couche et une troisième couche optiquement transparentes à un faisceau lumineux présentant la longueur d'onde λ, les guides d'onde et les déphaseurs optiques étant disposés dans la première couche.

Selon un mode de mise en œuvre, la section d'émission comprend uniquement la première couche.

Selon un mode de mise en œuvre, la première couche comprend un matériau diélectrique, avantageusement la troisième couche comprend également un matériau diélectrique.

Selon un mode de mise en œuvre, chaque déphaseur optique comprend un réseau de diffraction couplé à des moyens de déphasage destinés à imposer un déphasage au faisceau optique secondaire issu du guide d'onde auquel est optiquement couplé le déphaseur optique considéré.

Selon un mode de mise en œuvre, chaque réseau de diffraction est agencé pour que l'extraction lumineuse soit égale au niveau de la première face et de la deuxième face.

Selon un mode de mise en œuvre, chaque réseau de diffraction est agencé pour que l'extraction lumineuse au niveau de la première face soit supérieure à celle observée au niveau de la deuxième face.

Selon un mode de mise en œuvre, la première couche et la troisième couche comprennent du dioxyde de silicium, et la deuxième couche comprend du silicium.

Selon un mode de mise en œuvre, la pluralité de guides d'onde et/ou les réseaux de diffraction comprennent du nitrure de silicium.

Selon un mode de mise en œuvre, les déphaseurs optiques sont agencés en lignes parallèlement ou perpendiculairement à l'axe d'élongation.

Selon un mode de mise en œuvre, les déphaseurs optiques sont agencés de manière matricielle.

Selon un mode de mise en œuvre, l'actionneur est agencé de sorte que la flexion susceptible d'être imposée à la partie mobile par ledit actionneur s'effectue selon un plan perpendiculaire à la première et la deuxième face.

Selon un mode de mise en œuvre, l'actionneur comprend au moins un des moyens choisis parmi : des moyens électrostatiques, des moyens magnétiques, des moyens piézoélectriques, des moyens thermiques.

Selon un mode de mise en œuvre, l'actionneur est agencé de sorte que la torsion susceptible d'être imposée à la partie mobile par ledit actionneur s'effectue autour d'un axe d'élongation défini par l'extrémité fixe et l'extrémité libre.

## BRÈVE DESCRIPTION DES DESSINS

D'autres caractéristiques et avantages apparaîtront dans la description qui va suivre d'un scanner optique selon l'invention, donnés à titre d'exemples non limitatifs, en référence aux dessins annexés dans lesquels :

La figure 1 illustre une première architecture d'un dispositif de balayage lumineux connu de l'état de la technique, et notamment du document [1] cité à la fin de la description, le dispositif comprend notamment deux micro-miroirs montés pivotant chacun autour d'un axe pivot différent et non parallèles ;
La figure 2 illustre une deuxième architecture d'un dispositif de balayage lumineux connu de l'état de la technique, et notamment du document [1] cité à la fin de la description, le dispositif comprend notamment un micro-miroir monté pivotant autour de deux axes pivot différents et non parallèles ;

La figure 3 est une représentation schématique d'un scanner optique selon un plan de coupe perpendiculaire à la première face et comprenant l'axe d'élongation XX' selon un premier exemple de la présente invention ;

La figure 4 est une représentation partielle d'un scanner optique selon une vue à l'aplomb de la première face et illustrant un agencement des guides d'onde susceptible d'être mis en œuvre dans le cadre de la présente invention ;

La figure 5 est une illustration d'un déphaseur optique selon une première architecture susceptible d'être mise en œuvre dans le cadre de la présente invention ;

La figure 6 est une illustration d'un déphaseur optique (issu du document [3] cité la fin de la description) selon une deuxième architecture susceptible d'être mise en œuvre dans le cadre de la présente invention ;

La figure 7 est une représentation schématique du scanner optique réalisé selon le premier exemple et en fonctionnement ;

La figure 8 est une vue de détail d'un réseau de diffraction enrobé par la première couche, et qui comprend un guide d'onde base et des plots régulièrement espacés ;

La figure 9 est une représentation partielle d'un scanner optique selon une vue à l'aplomb de la première face et illustrant un agencement des réseaux de diffraction selon un deuxième exemple de la présente invention ;

La figure 10 est une représentation partielle d'un scanner optique selon une vue à l'aplomb de la première face et illustrant un agencement des réseaux de diffraction selon un troisième exemple de la présente invention ;

La figure 11 est une représentation mettant en œuvre deux scanners optique selon la présente invention ;

Les figures 12, 13, 14 et 15 sont des représentations schématiques d'étapes d'un procédé de fabrication du scanner optique selon la présente invention.

## EXPOSÉ DÉTAILLÉ DE MODES DE RÉALISATION PARTICULIERS

La présente invention concerne un scanner pourvu d'une poutre vibrante sur ou dans laquelle est formé un réseau à commande de phase destiné à extraire selon l'une et l'autre de deux faces parallèles de la poutre un rayonnement lumineux susceptible d'être émis par une source lumineuse.

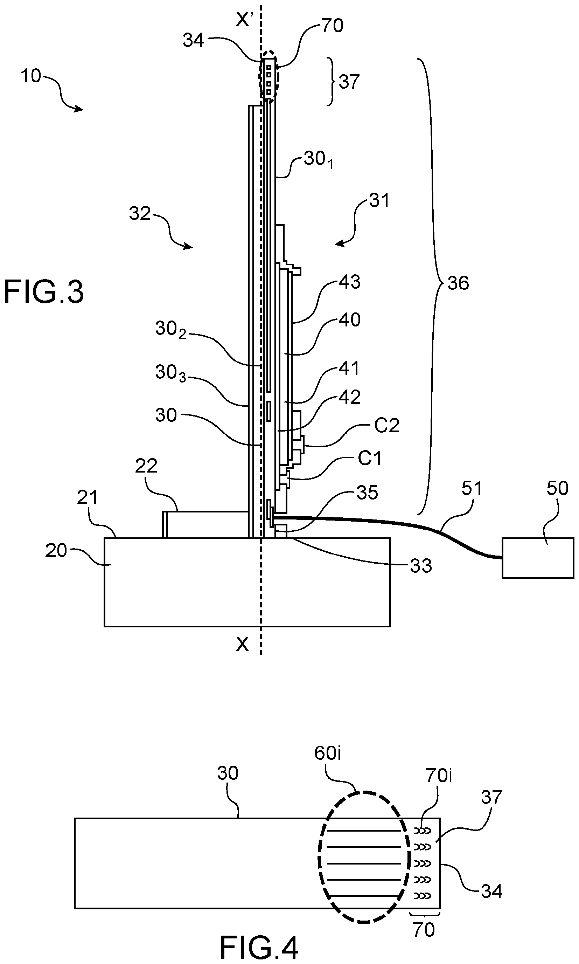

Ainsi la figure 3 est une représentation schématique d'un premier exemple de mise en œuvre d'un scanner 10 selon la présente invention.

Le scanner 10 comprend notamment un support plan 20 fixe pourvu d'une face principale 21. Le support plan 20 peut notamment être obtenu à partir d'un substrat semi-conducteur, par exemple du silicium.

L'invention n'est cependant pas limitée à cette seule mise en œuvre, et ledit support plan 20 peut comprendre tout autre matériau susceptible d'assurer la fonction de support.

Le scanner 10 comprend également une poutre 30 pourvue d'une première face 31 et d'une deuxième face 32, et qui s'étend, selon un axe l'élongation d'une extrémité fixe 33 vers une extrémité libre 34.

Par « poutre », on entend un élément mécanique solide de forme généralement allongée. À titre d'exemple, une poutre selon les termes de la présente invention peut être de forme parallélépipédique.

La poutre 30 comprend, par ailleurs, une partie mobile 36 qui s'étend de l'extrémité libre 34 vers l'extrémité fixe 33.

Par « partie mobile », on entend une partie de poutre susceptible de subir une déformation par flexion et/ou partorsion. Par exemple, la partie mobile peut subir une flexion selon une direction perpendiculaire à la première face et/ou une torsion autour d'un axe d'élongation XX' défini par l'extrémité fixe et l'extrémité libre.

Selon la présente invention, la poutre 30 est fixée perpendiculairement à la face principale 21. Une cale 22 peut être mise en œuvre afin d'assurer le maintien de la poutre 30 perpendiculairement à la face principale 21. Plus particulièrement, la cale 22, pour assurer ce maintien, peut être au contact d'une partie de la poutre 30, dite partie fixe 35, qui s'étend à partir de l'extrémité fixe 33 et est adjacente à la partie mobile 36.

La scanner 10 comprend également un actionneur 40 configuré pour imposer soit une flexion soit une torsion de la partie mobile.

L'actionneur 40 peut être commandé par des moyens de commande, par exemple des moyens de commande électronique, notamment équipés d'un microprocesseur ou d'un calculateur. Ces moyens de commande peuvent notamment être adaptés pour faire vibrer la poutre en flexion et/ou en torsion. Ces moyens de commande peuvent en particulier imposer une vibration à la poutre en flexion et/ou en torsion. Cette vibration peut notamment présenter une fréquence égale à la fréquence de résonnance de la poutre.

Une « flexion » de la poutre correspond à une déformation de cette dernière selon un plan perpendiculaire à la première face 31, tandis qu'une torsion correspond à une déformation autour de l'axe d'élongation XX'.

L'actionneur 40 peut par exemple comprendre des moyens choisis parmi : des moyens des électrostatiques, des moyens magnétiques, des moyens piézoélectriques, des moyens thermiques. L'invention n'est toutefois pas limitée à ces seuls moyens.

L'actionneur 40 peut être disposé au moins en partie sur la partie mobile 36. Plus particulièrement, l'actionneur 40 peut recouvrir partiellement la partie mobile 36 et la partie fixe 35 au niveau de la première face.

L'exemple représenté à la figure 3 met en œuvre un actionneur 40 piézoélectrique. En particulier, dans cet exemple, l'actionneur 40 comprend une couche de matériau piézoélectrique 41 intercalée entre deux électrodes 42 et 43 destinées à imposer une tension électrique non-nulle de part et d'autre de ladite couche de matériau piézoélectrique 41. A cet égard, l'actionneur 40 peut être pourvu de contacts C1 et C2 au niveau desquels une tension d'alimentation des électrodes peut être appliquée. Cette tension d'alimentation peut notamment être appliquée avec les moyens de commande. Sous l'action de cette tension électrique (champ de polarisation électrique), la couche de matériau piézoélectrique se contracte selon un plan perpendiculaire à la première face 31, et entraîne en flexion la partie mobile 36 de la poutre 30. A cet égard, et tel que précisé dans le document [2] cité à la fin de la description, plus le champ de polarisation électrique imposé à la couche de matériau piézoélectrique (par exemple un couche de PZT) est élevé, plus la flexion de l'ensemble formé par ladite couche et la poutre est importante. Cette flexion est dépendante non seulement des propriétés mécaniques et géométriques de la poutre mais également du champ de polarisation électrique imposé à la couche de matériau piézoélectrique.

La direction de fléchissement de la couche de matériau piézoélectrique peut dépendre du signe de la tension électrique imposée par les électrodes, notamment lorsque ladite couche comprend un matériau piézo électrique non ferroélectrique.

L'amplitude de fléchissement, quant à elle, peut dépendre de nombreux paramètres parmi lesquelles on peut citer : la raideur de la poutre, l'amplitude de la tension imposée par les électrodes, l'épaisseur de la couche de matériau piézoélectrique.

Plus particulièrement, l'amplitude de fléchissement d'une poutre, pour une charge donnée, est directement proportionnelle à la puissance quatre de sa longueur et inversement proportionnelle au produit de son épaisseur par son moment d'inertie.

En d'autres termes, l'amplitude de fléchissement d'une poutre croit avec sa longueur et/ou lorsque son épaisseur diminue.

Ainsi, et eu égard à ce qui précède, l'amplitude de fléchissement dépend des paramètres mécaniques et géométriques de la poutre, mais est également fonction du champ de polarisation imposé par les électrodes.

La poutre peut également présenter une flexion initiale qui exerce une influence sur l'amplitude de flexion de cette dernière.

De manière avantageuse, il est possible de faire vibrer la poutre, et plus particulièrement à sa fréquence de résonnance afin de conférer au scanner un meilleur facteur de qualité, et ainsi bénéficier du facteur de qualité mécanique. Un fonctionnement à la fréquence de résonnance permet également d'amplifier le mouvement de la poutre.

À cet égard, la fréquence de résonance d'une poutre de longueur L, de largueur b, d'épaisseur h et de densité ρ et de module d'Young E suit à la relation suivante :

$$\left(\frac{E}{\rho}\right)^{1/2} \frac{h}{L^2}$$

Ainsi, la fréquence de résonance augmente avec l'épaisseur et diminue lorsque sa longueur augmente. Cette diminution en fonction de l'épaisseur suit néanmoins une loi au carré et est donc plus marquée lorsqu'il s'agit de modifier la longueur.

En d'autres termes, la fréquence de résonance de la poutre peut être ajustée par son épaisseur et sa longueur.

La couche de matériau piézoélectrique peut comprendre au moins l'un des matériaux choisis parmi : PZT (Titano-Zirconate de Plomb) ou AIN (nitrure d'aluminium). D'autres matériaux piézoélectriques sont envisageables.

La poutre 30 peut présenter une épaisseur comprise entre 1 $\mu$m et quelques centaines de micromètres, une longueur comprise entre 100 $\mu$m et plusieurs millimètres, et une largeur comprise entre 10 $\mu$m et plusieurs millimètres.

L'épaisseur de la poutre est définie comme la distance séparant la première face et la deuxième face. La longueur de la poutre est quand à elle sa dimension mesurée selon la direction définie par l'axe d'élongation XX' tandis que sa largeur est sa dimension mesurée selon une direction perpendiculaire à celle définie par l'axe d'élongation XX' et l'épaisseur de ladite poutre.

La poutre 30 peut avantageusement comprendre de sa première face vers sa deuxième face, une première couche $30_1$, une deuxième couche $30_2$ et une troisième couche $30_3$.

Il apparaîtra plus clairement dans la suite de l'énoncé que la première couche $30_1$, et la troisième couche $30_3$ peuvent avantageusement comprendre un matériau diélectrique.

Le scanner optique 10 comprend également une source optique 50, destinée à émettre un faisceau lumineux sur ou dans la poutre 30 et plus particulièrement sur ou dans la première couche $30_1$.

A cet égard, la source optique 50 est destinée à émettre un faisceau optique principal d'une longueur d'onde λ Le faisceau optique principal est avantageusement quasi-monochromatique, voire monochromatique. La source optique 50 peut par exemple comprendre une source LASER.

La longueur d'onde λ peut être comprise entre 400 nm et 2500 nm, par exemple être égale à 905 nm, ou égale à 1330 nm ou encore égale à 1550 nm.

Le faisceau optique principal émis par la source optique 50 est avantageusement transmis au niveau de la poutre 30 par des moyens de couplage optique 51, par exemple par une fibre optique.

Le scanner optique 10 comprend également une pluralité de guides d'onde 60i disposés sur ou dans la poutre 30 et destinés à diviser le faisceau optique principal en une pluralité de faisceaux optiques secondaires. La figure 4 illustre à cet égard un agencement possible des guides d'onde 60i selon un vue à l'aplomb de la première face 31. Ces guides d'ondes sont, selon cet exemple, disposés parallèlement à l'axe d'élongation XX', et de sorte que le rapport entre leur espacement (en $\mu$m) et la longueur d'onde $\lambda$ (en nm) soit compris entre 0,5 et 10.

Les guides d'ondes peuvent par exemple être d'une longueur comprise entre une centaine de microns et une dizaine de millimètres, et être espacés les uns des autres d'une distance comprise entre une centaine de microns et une dizaine de millimètres.

L'exemple illustré à la figure 4 n'a pas vocation à limiter la présente invention à ce seul agencement, et il apparaîtra clairement dans la suite de l'énoncé que d'autres agencements et/ou géométries peuvent être considérées.

Le scanner optique 10 comprend également un réseau optique à commande de phase 70.

Le réseau à commande de phase 70 peut être piloté par les moyens de commande.

En particulier, ce réseau optique à commande de phase 70 comprend une pluralité de déphaseurs optiques 71i chacun couplé à un guide d'onde 60i.

Les déphaseurs optiques 71i sont par ailleurs disposés sur ou dans une section d'émission 37 de la partie mobile 36 et qui s'étend à partir de l'extrémité libre 34.

La section d'émission 37 présente en particulier une transparence adaptée pour permettre une extraction lumineuse à partir de la première face et de la deuxième face. En d'autres termes, le faisceau optique principal peut être extrait sous la forme d'un premier faisceau au niveau de la première face et d'un deuxième faisceau au niveau de la deuxième face.

Selon la présente invention, chaque déphaseur optique 70i peut comprendre un réseau de diffraction 71i couplé à des moyens de déphasage 72i.

En particulier, chaque moyen de déphasage 72i est destiné à imposer un déphasage au faisceau optique secondaire issu du guide d'onde 60i auquel est optiquement couplé le déphaseur optique considéré 70i. Des déphasages différents d'un moyen de déphasage à l'autre peuvent être mis en œuvre. Plusieurs manières de modifier l'indice effectif d'un guide d'onde et donc la phase sortante d'une certaine longueur d'onde de guide à commande électrique peuvent être prévues. La variation d'indice du matériau du guide peut être obtenue par effet thermo-optique, ou par effet électro-optique.

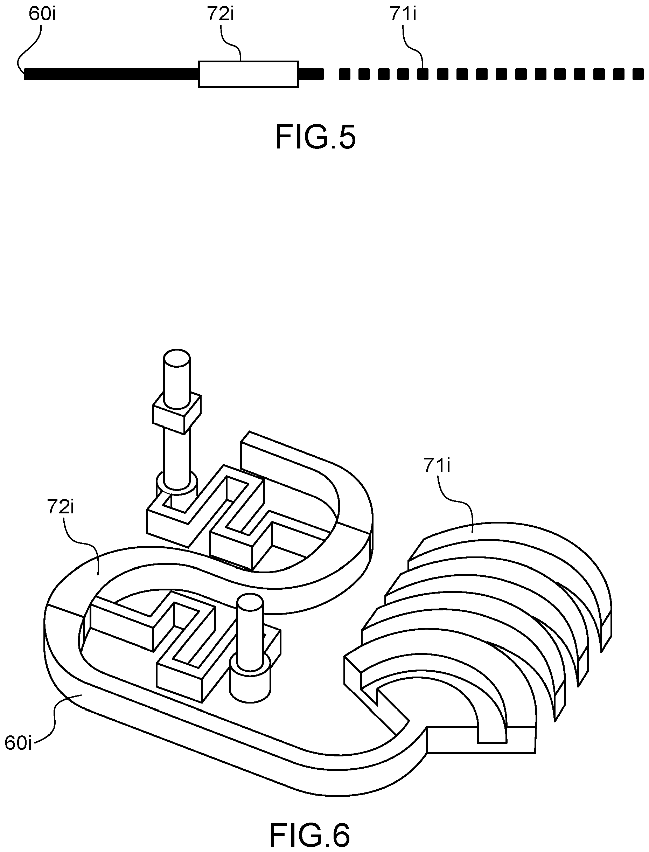

La figure 5 est une illustration d'un déphaseur optique 70i selon une première architecture susceptible d'être mise en œuvre dans le cadre de ce premier exemple. En particulier, le réseau de diffraction 71i est formé de plots alignés dans le prolongement du guide d'onde 60i, tandis que les moyens de déphasage 72i peuvent comprendre un élément chauffant disposé à l'aplomb du guide d'onde 60i et destinés à chauffer localement ce dernier afin de moduler son indice de réfraction.

La figure 6 est une illustration d'un déphaseur optique 70i selon une deuxième architecture susceptible d'être mise en œuvre dans le cadre de ce premier exemple. En particulier, le réseau de diffraction 71i est formé d'arcs pleins alignés, tandis que les moyens de déphasage 72i peuvent comprendre un élément chauffant destiné à chauffer localement le guide d'onde 60i afin de moduler son indice de réfraction.

Toujours selon ce premier exemple, les déphaseurs optiques peuvent être agencés en ligne perpendiculairement un axe d'élongation XX' défini par l'extrémité fixe et l'extrémité libre (figure 4).

Le scanner optique selon ce premier exemple permet de balayer l'espace de part et d'autre de la poutre 30 selon une première direction de balayage. Notamment, l'application d'une tension électrique au niveau des électrodes 42 et 43 permet d'imposer une flexion à la poutre. Cette flexion permet au premier faisceau et au deuxième faisceau de balayer chacun un demi-espace dits, respectivement, premier demi-espace E1 et deuxième demi-espace E2, selon une première gamme d'angle $\theta$ définie par l'amplitude de flexion de la poutre. L'angle $\theta$ peut alors être de quelques degrés, préférentiellement de quelques dizaines de degrés.

La mise en œuvre du réseau optique à commande de phase 70 permet d'imposer au premier faisceau et au deuxième faisceau une deuxième direction de balayage perpendiculaire à la première direction de balayage, et selon une deuxième gamme d'angle $\varphi$.

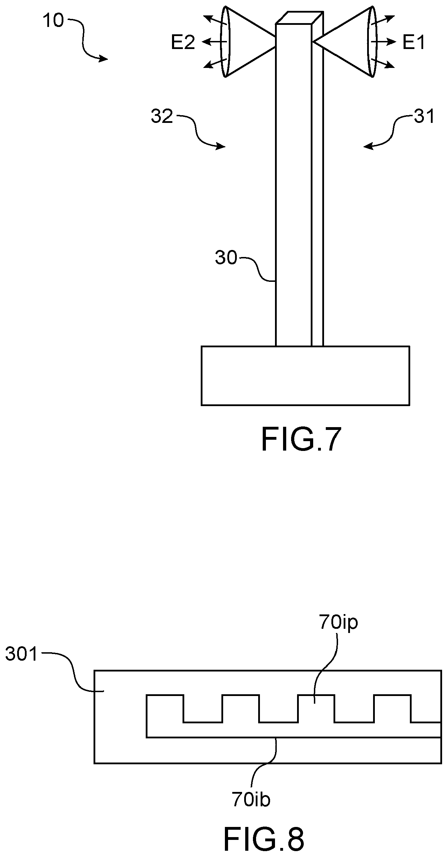

Dans le premier exemple, la première direction de balayage obtenue grâce à la mise en mouvement de la partie mobile de la poutre 30 est perpendiculaire à la deuxième direction de balayage obtenue grâce au déphasage de l'onde optique émise par le réseau optique à commande de phase 70. Ainsi, le premier faisceau et le deuxième faisceau peuvent balayer, respectivement, dans le premier demi-espace et le deuxième demi-espace une surface dont les limites sont définies par les valeurs maximales des angles $\theta$ et $\varphi$ (figure 7).

Selon une première variante de ce premier exemple, les guides d'onde et les déphaseurs optiques sont disposés dans la première couche $30_1$. En d'autres termes, la première couche $30_1$ forme une gaine autour des guides d'ondes.

Par ailleurs, toujours selon cette première variante, la section d'émission 37 comprend uniquement la première couche $30_1$ (figure 3). Ainsi, le deuxième faisceau susceptible d'être extrait au niveau de la deuxième face 32 n'est plus écranté/absorbé par la deuxième couche $30_2$ et la troisième couche $30_3$. Cet agencement per-

met de mettre en œuvre une deuxième couche faite de silicium et de considérer faisceau optique principal d'une longueur d'onde λ égale à 905 nm.

Selon une deuxième variante de ce premier exemple, qui peut reprendre les caractéristiques relatives à la première variante, chaque réseau de diffraction $70i$ peut être agencé pour que l'extraction lumineuse soit égale au niveau de la première face 31 et de la deuxième face 32.

Selon cette deuxième variante, chaque réseau de diffraction peut être symétrique par rapport à un plan médian de la première couche $30_1$. A cet égard, chaque réseau de diffraction peut reprendre les architectures représentées aux figures 5 et 6.

Selon une troisième variante de ce premier exemple, qui peut reprendre les caractéristiques relatives à la première variante, chaque réseau de diffraction est agencé pour que l'extraction lumineuse au niveau de la première face soit supérieure à celle observée au niveau de la deuxième face.

Par exemple, chaque réseau de diffraction $70i$ peut être dissymétrique par rapport à un plan médian de la première couche $30_1$. A cet égard, chaque réseau de diffraction $71i$ peut être formé sur une base. Plus particulièrement, le réseau de diffraction $71i$ peut comprendre des plots régulièrement disposés sur un guide d'onde.

A cet égard, la figure 8 est une vue de détail d'un tel réseau de diffraction $71i$ enrobé par la première couche $30_1$, et qui comprend le guide d'onde $71ib$ et les plots $71ip$ régulièrement espacés. L'invention n'est cependant pas limitée à cette seule architecture mettant en œuvre des plots. Plus particulièrement, des arcs pleins tels que ceux décrits en relation avec la figure 6 peuvent également être considérés.

Quelle que soit la variante considérée, la pluralité de guides d'onde et/ou les réseaux de diffraction peuvent comprendre du nitrure de silicium.

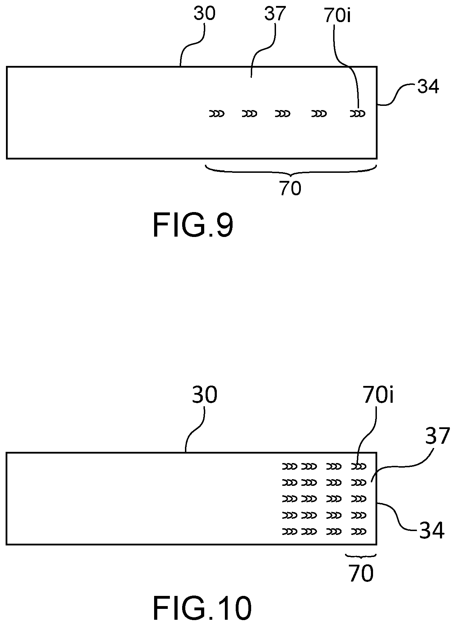

L'invention concerne également un deuxième exemple qui diffère du premier exemple en ce que les déphaseurs optiques sont agencés en lignes parallèlement l'axe d'élongation XX' (figure 9).

Le scanner optique selon ce deuxième exemple permet de balayer l'espace de part et d'autre de la poutre 30 selon une première direction de balayage. Notamment, l'application d'une tension électrique au niveau des électrodes 42 et 43 permet d'imposer une flexion à la poutre. Cette flexion permet au premier faisceau et au deuxième faisceau de balayer chacun un demi-espace dits, respectivement, premier demi-espace E1 et deuxième demi-espace E2, selon une première gamme d'angle θ définie par l'amplitude de flexion de la poutre. L'angle θ peut alors être de quelques degrés, préférentiellement de quelques dizaines de degrés.

La mise en œuvre du réseau optique à commande de phase 70 permet d'imposer au premier faisceau et au deuxième faisceau, toujours selon la première direction de balayage et selon une deuxième gamme d'angle φ.

Selon ce deuxième exemple, les deux gammes de balayage se cumulent de sorte que l'angle de balayage du premier faisceau et du deuxième faisceau peut varier entre θ + φ et θ - φ.

L'invention concerne un troisième exemple qui reprend pour l'essentiel l'ensemble des caractéristiques du premier exemple. Toutefois, dans ce troisième exemple les déphaseurs optiques $70i$ sont agencés de manière matricielle (figure 10). Par « agencé de manière matricielle », on entend agencés selon N lignes et M colonnes.

Selon ce troisième exemple, il est possible de balayer le premier demi-espace et le deuxième demi-espace selon deux directions de balayage sans nécessairement mettre en œuvre l'actionneur 40.

Les trois exemples de mise en œuvre ont été présentés dans le cadre d'une flexion de la poutre. Il est toutefois possible d'imposer une déformation en torsion de la poutre 30 autour de l'axe d'élongation XX'.

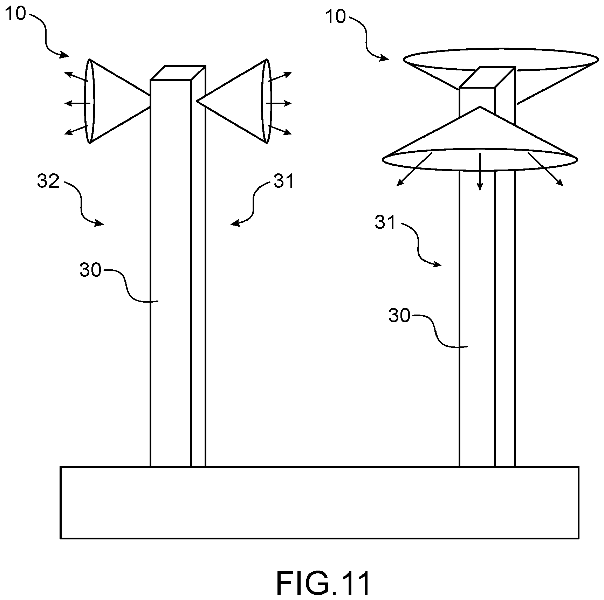

Par ailleurs, quelle que soit l'exemple considéré, il est possible d'associer au moins deux scanners optiques présentant chacun une orientation différente. Par exemple, deux scanners optiques peuvent positionnés à proximité l'un de l'autre et de sorte les premières faces 31 de chacune des deux poutres 30 soient perpendiculaires (figure 11).

L'invention concerne également un procédé de fabrication du scanner optique 10.

Ce procédé comprend notamment une étape qui consiste à fournir un substrat de matériau semi-conducteur, par exemple de silicium.

Une couche d'oxyde 110, par exemple d'oxyde de silicium, d'une épaisseur de 1 $\mu$m peut être formée sur une face avant 101 dudit substrat 100. Cette couche d'oxyde peut notamment être formée par oxydation thermique.

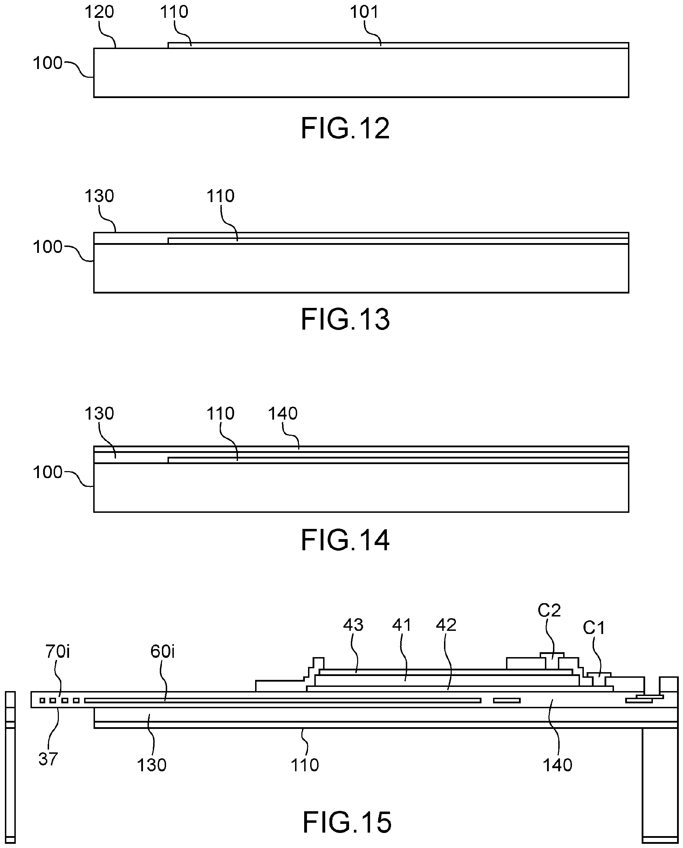

Un retrait partiel de la couche d'oxyde 110 dans une zone 120 délimitant la section d'émission est par ailleurs exécuté. Ce retrait partiel peut impliquer une séquence de photolithographie et une gravure (figure 12).

Le procédé comprend également une étape de formation d'une couche de poly silicium 130, par exemple d'une épaisseur de 9 $\mu$m, en recouvrement zone 120 et de la couche d'oxyde 110.

Cette étape peut être suivie d'une étape d'aplanissement de la couche de poly silicium 120, par exemple une étape de polissage mécano chimique (figure 13).

Une deuxième couche d'oxyde 140 est ensuite formée en recouvrement de la couche de poly silicium 130.

La deuxième couche d'oxyde 140 est alors recouverte d'une couche de nitrure de silicium au niveau de laquelle les guides d'ondes $60i$ et les réseaux de diffraction $71i$ sont formés par une étape de gravure. Ces derniers peuvent ensuite être encapsulés avec une troisième couche d'oxyde 150 qui forme avec la deuxième couche d'oxyde la première couche $30_1$ décrite précédemment.

Cette séquence est alors suivie de la formation de l'électrode 42, de la couche de matériau piézoélectrique 41 (notamment du PZT) et de la formation de l'électrode 43. Une couche de PZT, ainsi que les électrodes peuvent être formées selon différents procédés qui peuvent notamment comprendre un report, un dépôt. Des prises de contact C1 et C2 destinées à contacter électriquement, respectivement, l'électrode 42 et l'électrode 43 sont également formées.

Il est ensuite procédé à un relâchement de la poutre 30 formée par les couches 110, 130, 140 et 150 par gravure du substrat 100 à partir d'une face arrière opposée à la face avant 101.

Cette gravure est également suivie d'un retrait des couches 110 et 130 au niveau de la section émissive 37.

Ce procédé n'est donné qu'à titre d'exemple, et n'est pas de nature à limiter la présente invention à un scanner optique obtenu par ce seul procédé.

Le scanner 10 selon la présente invention peut avantageusement être mis en œuvre dans un projecteur d'images de taille réduite (par exemple un pico-projecteur) dans un équipement électronique mobile, et plus particulièrement, un téléphone portable, une montre connectée, dans des équipements de projection intra rétinienne (pour la réalité augmentée).

La scanner peut également être mis en œuvre dans le cadre d'application 3D, et notamment d'imagerie 3D.

Le scanner 10 peut également former la partie active d'un LIDAR, et par exemple être mis en œuvre dans un véhicule autonome.

## RÉFÉRENCES

[1] Sven Holmstrom et al., "MEMS laser scanners : a review", Journal of Microelectromechanical Systems . April 2014, DOI: 10.1109/JMEMS.2013.2295470;
[2] Section 13.5.3 de l'ouvrage « Intégration of Ferroelectric and Piezoelectric Thin Films » de Defay;
[3] Jie Sun et al., « Large-scale nanophotonic phased array », Nature, 11727, vol 493, 195-199, January 2013.

## Revendications

1. Scanner optique (10) qui comprend :

   - un support plan (20) fixe ;
   - une poutre (30), pourvue d'une première face (31) et d'une deuxième face (32), maintenue solidaire par une de ses extrémités, dite extrémité fixe (33), au support plan (20) et perpendiculaire à une face principale (21) dudit support ;
   - un actionneur (40) agencé pour imposer soit une flexion soit une torsion à une partie mobile (36) de la poutre (30) s'étendant à partir d'une extrémité libre (34) de ladite poutre (30) et opposée à l'extrémité fixe (33) ;
   - une source optique (50) apte à émettre un faisceau optique principal d'une longueur d'onde λ ; **caractérisé en ce que** le scanner optique comprend de plus
   - une pluralité de guides d'ondes (60i) disposés sur ou dans la poutre (30) et destinés à diviser le faisceau optique principal en une pluralité de faisceaux optiques secondaires ;
   - un réseau optique à commande de phase (70) qui comprend une pluralité de déphaseurs optiques (70i) chacun couplé à un guide d'onde (60i), disposés sur ou dans une section d'émission (37) de la partie mobile (36) et qui s'étend à partir de l'extrémité libre (34), la section d'émission présentant une transparence adaptée pour permettre une extraction lumineuse à partir de la première face (31) et de la deuxième face (32).

2. Scanner optique (10) selon la revendication 1, dans lequel la poutre (30) comprend de sa première face (31) vers sa seconde face une première couche ($30_1$), une deuxième couche ($30_2$) et une troisième couche ($30_3$) optiquement transparentes à un faisceau lumineux présentant la longueur d'onde λ, les guides d'onde et les déphaseurs optiques étant disposés dans la première couche.

3. Scanner optique (10) selon la revendication 2, dans lequel la section d'émission comprend uniquement la première couche.

4. Scanner optique (10) selon la revendication 2 ou 3, dans lequel la première couche ($30_1$) comprend un matériau diélectrique, avantageusement la troisième couche comprend également un matériau diélectrique.

5. Scanner optique (10) selon l'une des revendications 2 à 4, dans lequel chaque déphaseur optique comprend un réseau de diffraction ($71i$) couplé à des moyens de déphasage ($72i$) destinés à imposer un déphasage au faisceau optique secondaire issu du guide d'onde auquel est optiquement couplé le déphaseur optique considéré.

6. Scanner optique (10) selon la revendication 5, dans lequel chaque réseau de diffraction ($71i$) est agencé pour que l'extraction lumineuse soit égale au niveau de la première face (31) et de la deuxième face (32).

7. Scanner optique (10) selon la revendication 5, dans lequel chaque réseau de diffraction ($71i$) est agencé pour que l'extraction lumineuse au niveau de la première face (31) soit supérieure à celle observée au niveau de la deuxième face (32).

8. Scanner optique (10) selon l'une des revendications 2 à 7, dans lequel la première couche ($30_1$) et la troisième couche comprennent du dioxyde de silicium, et la deuxième couche comprend du silicium.

9. Scanner optique (10) selon l'une des revendications 2 à 8, dans lequel la pluralité de guides d'onde et/ou les réseaux de diffraction comprennent du nitrure de silicium.

10. Scanner optique (10) selon l'une des revendications 1 à 9, dans lequel les déphaseurs optiques sont agencés en lignes parallèlement ou perpendiculairement à un axe d'élongation XX' défini par l'extrémité fixe (33) et l'extrémité libre (34).

11. Scanner optique (10) selon l'une des revendications 1 à 9, dans lequel les déphaseurs optiques sont agencés de manière matricielle.

12. Scanner optique (10) selon l'une des revendications 1 à 11, dans lequel l'actionneur (40) est agencé de sorte que la flexion susceptible d'être imposée à la partie mobile (36) par ledit actionneur (40) s'effectue selon un plan perpendiculaire à la première et la deuxième face (32).

13. Scanner optique (10) selon la revendication 12, dans lequel l'actionneur (40) comprend au moins un des moyens choisis parmi : des moyens des électrostatiques, des moyens magnétiques, des moyens piézoélectriques, des moyens thermiques.

14. Scanner optique (10) selon l'une des revendications 1 à 11, dans lequel l'actionneur (40) est agencé de sorte que la torsion susceptible d'être imposée à la partie mobile (36) par ledit actionneur (40) s'effectue autour d'un axe d'élongation défini par l'extrémité fixe (33) et l'extrémité libre (34).


**Patentansprüche**

1. Optischer Scanner (10), der umfasst:

   - einen festen ebenen Halter (20);
   - einen Balken (30), der mit einer ersten Fläche (31) und mit einer zweiten Fläche (32) versehen ist, der anhand von einem seiner Enden, bezeichnet als festes Ende (33), mit dem ebenen Halter (20) und senkrecht zu einer Hauptfläche (21) des Halters in Verbindung gehalten wird;
   - einen Aktuator (40), der eingerichtet ist, um entweder einen beweglichen Teil (36) des Balkens (30) zu biegen oder zu verdrehen, der sich ab einem freien Ende (34) des Balkens (30) und gegenüber dem festen Ende (33) erstreckt;
   - eine optische Quelle (50), die imstande ist, einen optischen Hauptstrahl mit einer Wellenlänge λ zu senden;

   **dadurch gekennzeichnet, dass** der optische Scanner zusätzlich umfasst:

   - eine Vielzahl von Wellenleitern (60i), die auf oder im Balken (30) angeordnet und bestimmt sind, den optischen Hauptstrahl in eine Vielzahl sekundärer optischer Strahlen zu unterteilen;
   - ein optisches Netzwerk mit Phasensteuerung (70), das eine Vielzahl optischer Phasenverschieber (70i) umfasst, von denen jeder an einen Wellenleiter (60i) gekoppelt ist, die auf oder in einem Sendeabschnitt (37) des beweglichen Teils (36) angeordnet sind und der sich ab dem freien Ende (34) erstreckt, wobei der Sendeabschnitt eine Transparenz aufweist, die geeignet ist, um eine Lichtextraktion ab der ersten Fläche (31) und der zweiten Fläche (32) zu gestatten.

2. Optischer Scanner (10) nach Anspruch 1, wobei der Balken (30) von seiner ersten Fläche (31) zu seiner zweiten Fläche eine erste Schicht ($30_1$), eine zweite Schicht ($30_2$) und eine dritte Schicht ($30_3$) umfasst, die für einen Lichtstrahl mit der Wellenlänge λ optisch transparent sind, wobei die Wellenleiter und die optischen Phasenverschieber in der ersten Schicht angeordnet sind.

3. Optischer Scanner (10) nach Anspruch 2, wobei der Sendeabschnitt nur die erste Schicht umfasst.

4. Optischer Scanner (10) nach Anspruch 2 oder 3, wobei die erste Schicht ($30_1$) ein dielektrisches Material umfasst, wobei die dritte Schicht in vorteilhafter Weise ebenfalls ein dielektrisches Material umfasst.

5. Optischer Scanner (10) nach einem der Ansprüche 2 bis 4, wobei jeder optische Phasenverschieber ein Diffraktionsnetz (71i) umfasst, das an Phasenverschiebungsmittel (72i) gekoppelt ist, die bestimmt sind, den zweiten optischen Strahl, der von dem Wellenleiter ausgeht, der an den entsprechenden optischen Phasenverschieber optisch gekoppelt ist, phasenzuverschieben.

6. Optischer Scanner (10) nach Anspruch 5, wobei jedes Diffraktionsnetz (71i) eingerichtet ist, damit die Lichtextraktion im Bereich der ersten Fläche (31) und der zweiten Fläche (32) gleich ist.

7. Optischer Scanner (10) nach Anspruch 5, wobei jedes Diffraktionsnetz (71i) eingerichtet ist, damit die Lichtextraktion im Bereich der ersten Fläche (31) größer als die ist, die im Bereich der zweiten Fläche (32) beobachtet wird.

8. Optischer Scanner (10) nach einem der Ansprüche 2 bis 7, wobei die erste Schicht ($30_1$) und die dritte Schicht Siliziumdioxid umfassen und die zweite Schicht Silizium umfasst.

9. Optischer Scanner (10) nach einem der Ansprüche 2 bis 8, wobei die Vielzahl der Wellenleiter und/oder die Diffraktionsnetze Siliziumnitrid umfassen.

10. Optischer Scanner (10) nach einem der Ansprüche 1 bis 9, wobei die optischen Phasenverschieber in Reihen eingerichtet sind, die parallel oder senkrecht zu einer Elongationsachse XX' sind, die von dem festen Ende (33) und dem freien Ende (34) definiert ist.

11. Optischer Scanner (10) nach einem der Ansprüche 1 bis 9, wobei die optischen Phasenverschieber matrixartig eingerichtet sind.

12. Optischer Scanner (10) nach einem der Ansprüche 1 bis 11, wobei der Aktuator (40) derart eingerichtet ist, dass die Biegung, der der bewegliche Teil (36) durch den Aktuator (40) unterzogen werden kann, in einer Ebene erfolgt, die senkrecht zur ersten und zur zweiten Fläche (32) ist.

13. Optischer Scanner (10) nach Anspruch 12, wobei der Aktuator (40) mindestens eins der Mittel umfasst, die aus elektrostatischen Mitteln, magnetischen Mitteln, piezoelektrischen Mitteln, thermischen Mitteln ausgewählt sind.

14. Optischer Scanner (10) nach einem der Ansprüche 1 bis 11, wobei der Aktuator (40) derart eingerichtet ist, dass die Verdrehung, der der bewegliche Teil (36) durch den Aktuator (40) unterzogen werden kann, um eine Elongationsachse erfolgt, die von dem festen Ende (33) und dem freien Ende (34) definiert ist.

**Claims**

1. An optical scanner (10) which comprises:

   - a fixed planar support (20);
   - a beam (30), provided with a first face (31) and with a second face (32), held secured by one of its ends, called fixed end (33), to the planar support (20) and perpendicular to a main face (21) of said support;
   - an actuator (40) arranged to impart either a bending or a torsion on a movable portion (36) of the beam (30) extending from a free end of said beam and opposite to the fixed end (33);
   - an optical source (50) adapted to emit a main optical beam with a wavelength $\lambda$; **characterized in that** the optical scanner further comprises:

      - a plurality of waveguides (60i) disposed on or in the beam (30) and intended to split the main optical beam into a plurality of secondary optical beams;
      - an optical phased array (70) which comprises a plurality of optical phase-shifters (70i) each coupled to a waveguide (60i), disposed on or in an emission section (37) of the movable portion (36) and which extends from the free end (34), the emission section having a transparency adapted to enable light extraction from the first face (31) and from the second face (32).

2. The optical scanner (10) according to claim 1, wherein the beam (30) comprises from its first face (31) towards its second face a first layer ($30_1$), a second layer ($30_2$) and a third layer ($30_3$) optically transparent to a light beam having a wavelength $\lambda$, the waveguides and the optical phase-shifters being disposed in the first layer.

3. The optical scanner (10) according to claim 2, wherein the emission section comprises only the first layer.

4. The optical scanner (10) according to claim 2 or 3, wherein the first layer ($30_1$) comprises a dielectric material, advantageously the third layer also comprises a dielectric material.

5. The optical scanner (10) according to any of the claims 2 to 4, wherein each optical phase-shifter comprises a diffraction grating (71i) coupled to phased-shifting means (72i) intended to impart a phase-shift on the secondary optical beam originating from the waveguide to which the considered optical phase-shifter is optically coupled.

6. The optical scanner (10) according to claim 5, wherein each diffraction grating (71i) is arranged so that the light extraction is equal at the first face (31) and the second face (32).

7. The optical scanner according to claim 5, wherein each diffraction grating (71i) is arranged so that the light extraction at the first face (31) is higher than the one observed at the second face (32).

8. The optical scanner (10) according to any of the claims 2 to 7, wherein the first layer and the third layer comprise silicon dioxide, and the second layer comprises silicon.

9. The optical scanner (10) according to any of the claims 2 to 8, wherein the plurality of waveguides and/or the diffraction gratings comprise silicon nitride.

10. The optical scanner (10) according to any of the claims 1 to 9, wherein the optical phase-shifters are arranged in rows parallel or perpendicular to an axis of elongation XX' defined by the fixed end (33) and the free end (34).

11. The optical scanner (10) according to any of the claims 1 to 9, wherein the optical phase-shifters are arranged in a matrix-like manner.

12. The optical scanner (10) according to any of the claims 1 to 11, wherein the actuator (40) is arranged so that the bending that could be imparted on the movable portion (36) by said actuator (40) is performed according to a plane perpendicular to the first and second faces (32).

13. The optical scanner (10) according to claim 12, wherein the actuator (40) comprises at least one of the means selected amongst: electrostatic means, magnetic means, piezoelectric means, thermal means.

14. The optical scanner according to any of the claims 1 to 11, wherein the actuator (40) is arranged so that the torsion that could be imparted on the movable portion (36) by said actuator (40) is performed about an axis of elongation defined by the fixed end (33) and the free end (34).

FIG.1

FIG.2

FIG.3

FIG.4

FIG.5

FIG.6

FIG.7

FIG.8

EP 3 933 485 B1

FIG.9

FIG.10

16

FIG.11

FIG.12

FIG.13

FIG.14

FIG.15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2018222727 A

**Littérature non-brevet citée dans la description**

- **SVEN HOLMSTROM et al.** MEMS laser scanners : a review. *Journal of Microelectromechanical Systems,* Avril 2014

- **JIE SUN et al.** Large-scale nanophotonic phased array. *Nature,* Janvier 2013, vol. 493, 195-199